# EUROPÄISCHE PATENTSCHRIFT

(11) **EP 0 934 366 B1**
(45) Veröffentlichungstag und Bekanntmachung des Hinweises auf die Patenterteilung: **11.12.2002**
(21) Anmeldenummer: 97945856.9
(22) Anmeldetag: 17.10.1997
(51) Int. Cl.: C09D 5/00, C09D 163/00, C09D 175/00

(54) **LÖSUNGSMITTELFREIE STRAHLUNGSHÄRTBARE PRIMER**
SOLVENTLESS PRIMERS WHICH ARE HARDENABLE BY RADIATION
APPR TS DURCISSABLES PAR RAYONNEMENT ET EXEMPTS DE SOLVANT

(30) Priorität: 26.10.1996 DE 19644590
(43) Veröffentlichungstag der Anmeldung: 11.08.1999
(73) Patentinhaber: Henkel Kommanditgesellschaft auf Aktien, 40589 Düsseldorf (DE)
(72) Erfinder: KINZELMANN, Hans-Georg, Cary, NC 27513 (US); DROBNIK, Michael, D-40627 Düsseldorf (DE)
(86) Internationale Anmeldenummer: EP9705752
(87) Internationale Veröffentlichungsnummer: WO98018868

(56) Entgegenhaltungen:
- EP-A- 0 326 917
- WO-A-96/13538
- US-A- 4 412 048
- US-A- 4 600 640
- US-A- 5 328 940

## Beschreibung

Die Erfindung betrifft die Verwendung strahlenhärtbarer Zusammensetzungen, die lösungsmittelfrei sind und kationische und/oder radikalisch härtbare Vernetzungssysteme enthalten, als Haftvermittler (Primer).

Bei einer Vielzahl von Beschichtungen werden Haftvermittler (Primer) eingesetzt, die eine Verklebung der Beschichtung mit dem Substrat erst ermöglichen bzw. die Haftung deutlich steigern. Primer werden auf schwierig zu beschichtenden Untergründen eingesetzt, z.B. bei der Beschichtung von flexiblen Trägermaterialien (Folien) und starren Trägermaterialien. Insbesondere werden Primer eingesetzt bei der Beschichtung dieser Materialien mit Polyvinylidenchlorid (PVDC), Hotmelts (Schmelzklebstoffe), Heißsiegellacken, Silikon, Druckfarben oder -lacken, Metallisierung sowie Extrusionsbeschichtung/Extrusionskaschierung mit Polyethylen (PE) oder Polypropylen (PP).

Gemäß Stand der Technik werden bei derartigen Beschichtungen lösungsmittelhaltige Primer-Zusammensetzungen eingesetzt, die neben den Lösungsmitteln als Reaktivkomponente beispielsweise feuchtigkeitshärtende Polyurethan-Prepolymere enthalten. Diese lösungsmittelhaltigen Primer-Zusammensetzungen erfüllen zwar die an sie gestellten technischen Anforderungen sehr gut, unter heutigen strengen Umweltschutzauflagen in bezug auf die Verhinderung bzw. Minimierung der Emission an flüchtigen organischen Lösungsmitteln sind jedoch aufwendige Rückführungs- oder Verbrennungsanlagen notwendig.

In neuerer Zeit sind daher vielfach wässrige Dispersionen oder Lösungen für diesen Zweck vorgeschlagen worden. So beschreibt die DE-A-4408487 eine wässrige PolyurethanPrimer-Zusammensetzung, bestehend aus einer Dispersion eines OH-funktionellen Polyurethan-Prepolymers und einer lsocyanatkomponente.

Diese Primer-Zusammensetzung eignet sich für PVC-Produkte, speziell PVC-Profile, zur Kaschierung von PVC-, Polyethersulfon-, Polyolefin- oder Polymethacrylatfilmen mit Kunststoffprodukten, insbesondere in Zusammenhang mit der Verwendung von (reaktiven) Schmelzklebstoffen. Diese Primer-Zusammensetzungen erfüllen die Forderung nach Freiheit von organischen Lösungsmitteln, bei der großflächigen Applikation in schnell laufenden Beschichtungsmaschinen muß jedoch ein erheblicher Aufwand zum Trocknen der wässrigen Primerschicht getrieben werden. Bei temperaturempfindlichen Substraten kommt erschwerend hinzu, dass keine hohen Trockentemperaturen verwendet werden können, so daß sich kurze Trocken- bzw. Ablüftezeiten mit wässrigen Systemen kaum verwirklichen lassen.

Es bestand also die Aufgabe, eine Primer-Zusammensetzung bereitzustellen, die sowohl im wesentlichen frei von flüchtigen organischen Lösungsmitteln als auch frei von Wasser als Lösungs- bzw. Dispergiermittel ist und die sich zur haftvermittelnden Beschichtung bei der Beschichtung von temperaturempfindlichen Substraten der oben bezeichneten Art eignet. Eine derartige Primer-Zusammensetzung soll die folgenden Anforderungen erfüllen:
- im wesentlichen frei von organischen Lösungsmitteln und/oder Wasser
- Verarbeitungstemperatur unter 150 °C, vorzugsweise unter 100 °C
- Verarbeitungsviskosität unter 5.000 mPas bei der Verarbeitungstemperatur
- auf gängigen Verarbeitungsanlagen sollen Auftragsgewichte für den Primer von wesentlich weniger als 5g/m² möglich sein
- die Haftvermittlerschicht soll eine hohe Kohäsion und eine geringe Oberflächenklebrigkeit haben
- es soll sowohl eine "in-line"-Primerung als auch eine "off-line"-Primerung möglich sein.
Unter "in-line"-Primerung wird dabei verstanden, dass sich in einem Arbeitsgang an die Beschichtung mit der Primer-Zusammensetzung eine weitere Beschichtung auf diese Primerschicht anschließt. Bei der "off-line"-Primerung erfolgt zunächst der Primerauftrag und zu einem späteren Zeitpunkt die weitere Beschichtung.

Erfindungsgemäß wurde die Aufgabe gelöst durch die Bereitstellung von lösungsmittelfreien strahlungshärtbaren Zusammensetzungen, die wie handelsübliche lösungsmittelfreie Kaschierklebstoffe aufgetragen werden, wobei diese Zusammensetzungen erfindungsgemäß eine Viskosität von unter 5.000 mPas bei Temperaturen unterhalb von 100°C haben. Erfindungsgemäß wird unmittelbar nach dem Auftrag des Primers durch UV-Bestrahlung oder EiektronenstrahlBestrahlung das Molekulargewicht der Zusammensetzung durch Vernetzungsreaktion drastisch erhöht. Die Beschichtung kann anschließend in einem Arbeitsgang (in-line) oder in zwei Arbeitsgängen (off-line) mit zwischenzeitlichem Aufwickeln der Trägerbahn erfolgen. Bei der off-line-Arbeitsweise darf der Primer beim Aufwickeln keine Oberflächenklebrigkeit haben, damit eine Anhaften auf der Trägerrückseite vermieden wird, da ansonsten die Rolle des bahnenförmigen Materials verblocken würde.

Die strahlenhärtbaren Primer können dabei kationisch, radikalisch oder durch eine Kombination beider Polymerisationsmechanismen (Hybridsysteme) gehärtet werden.

Strahlenhärtbare Polymersysteme auf der Basis von cycloaliphatischen Epoxiden sind im Prinzip bekannt. So beschreibt die Firmenbroschüre "Cyracure, Cycloaliphatic epoxides" der Fa. Union Carbide Chemicals and Plastic Company Inc. kationische UV-härtbare Bindemittelsysteme auf der Basis von gemischten cycloaliphatischen Epoxiden, Polycaprolactondiolen, Reaktivverdünnern auf der Basis von aliphatischen oder cycloaliphatischen Epoxiden sowie Triarylsulfoniumhexafluorophosphatsalzen oder Triarylsulfoniumhexafluoroantimonatsalzen als Photoinitiator. Als Anwendungen werden Lacke für Dosen und Deckel, dekorative Metallbeschichtung, lithographische Druckfarben, Papierbeschichtung und dergleichen angegeben. Über eine Anwendbarkeit derartiger Zusammensetzungen für Primer im Sinne der vorliegenden Erfindung macht diese Broschüre keinerlei Angaben.

Auch radikalisch härtende Systeme, die in Gegenwart eines Photoinitiators nach UV-Bestrahlung oder ohne Photoinitiator nach Elektronenbestrahlung härten, sind im Prinzip bekannt. So beschreibt z.B. die EP-A-326917 Klebstoffmischungen, die ein Hydroxylgruppen-aufweisendes Polyurethanpolymer mit einem Molekulargewicht von vorzugsweise 100000 bis 300000, photopolymerisierbare, ethylenisch ungesättigte Verbindungen, ggf. einen Photoinitiator sowie übliche Klebstoffhilfsmittel (Tenside, Adhäsionsverbesserer, Tackifier) enthalten. Diese Klebstoffmischungen sind strahlenhärtbar und thermisch aktivierbar. Diese Zusammensetzungen eignen sich zur Verwendung als Klebstoffe bei der Verklebung von Kunststoffmaterialien, Angaben über ihre Eignung als Haftvermittler-Beschichtung für schwierig zu beschichtende Untergründe werden nicht gemacht.

Hybridsysteme, die durch Kombination von kationischer und radikalischer Polymerisation aushärten, bestehen beispielsweise aus Vinylethem und Acrylatoligomeren und enthalten sowohl einen kationischen als auch einen radikalischen Photoinitiator. Derartige Hybrid-Formulierungen werden beispielsweise in der Firmenbroschüre "Rapi Cure Hybrid Formulations for High Humidity Environments" der Fa. International Specialty Products beschrieben. Als Anwendungsgebiete werden dort UV-härtbare Klarlacke für Papier, Weich-PVC, Polycarbonat und Polyester angegeben.

Strahlenhärtbare Zusammensetzungen auf der Basis von Epoxyverbindungen, Hydroxy-terminiertem Polyurethanpolymer und einem Photoinitator und deren Verwendung als Kaschierkleber werden in der US-A-5328940 beschrieben. Angaben zu lösungsmittelfreien strahlenhärtbaren Primerzusammensetzungen sind der Lehre der US-A-5328940 nicht zu entnehmen.

Die erfindungsgemäßen radikalisch härtenden Primer-Zusammensetzungen basieren auf Styrol-, Acrylat- und/oder Methacrylatmonomeren (ggf. in Gegenwart von Acrylat- bzw. Methacrylatfunktionalisierten Prepolymeren). Beispiele für bevorzugt einzusetzende ethylenisch ungesättigte Komponen-ten der vorgenannten Art sind Butyl-, Hexyl-, Ethylhexyl-, Dodecyl-, Dicyclopentadienyl-, Hydroxyethyl-, 2-Hydroxypropyl-, 4-Hydroxybutyl-, 2-Methoxyethyl-, 2-Ethoxyethyl-,2-(2-Ethoxyethoxy)-ethyl-, Tetrahydrofurfurylacrylat, N,N-Dimethacrylamid, Ethylenglykoldiacrylat, Butandiol-, Hexandiol-, Neopentylglykoldiacrylat, Trimethylolpropan-triacrylat, Pentaerythryttetraacrylat sowie die entsprechenden Methacrylate, ggf. Vinylpyrrolidon und Divinylimidazol.

Weiterer Bestandteil dieser radikalisch härtenden Systeme können hydroxyfunktionelle Polyurethan-Prepolymere sein, die in an sich bekannter Weise aus Polyetherpolyolen oder Polyesterpolyolen und Diisocyanaten mit stöchiometrischem Überschuss der OH-Komponente hergestellt werden.

Bei Härtung durch UV-Licht enthalten diese Primer-Zusammensetzungen noch geeignete Photoinitiatoren, z.B. Benzoin, Benzoinmethylether, Benzoinisopropylether, Benzophenon, Michlers Keton, 2-Hydroxy-2-Methylpropiophenon, Benzildimethylketal, Acetophenon, α,α-Dimethoxyacetophenon oder ähnliche Verbindungen.

Dabei muss das Molekulargewicht der OH-funktionelien Polyurethane sowie das Verhältnis der meist niederviskosen und ethylenisch ungesättigten Komponenten so aufeinander abgestimmt werden, dass die Verarbeitungsviskosität bei der Verarbeitungstemperatur deutlich unter 5000 mPas bleibt. Insbesondere bei der off-line-Primerung ist zusätzlich darauf zu achten, dass die Primerschicht keine Oberflächenklebrigkeit nach der Bestrahlung mehr besitzt.

Wegen ihrer geringen Sauerstoffempfindlichkeit werden kationische Systeme bzw. Hybridsysteme für die erfindungsgemäßen strahlenhärtbaren Primer-Zusammensetzungen besonders bevorzugt. Die kationischen Systeme sind dabei auf der Basis cycloaliphatischer Polyepoxide und ggf. aliphatischer bzw. cycloaliphatischer Epoxide als Reaktivverdünner, hydroxyfunktioneller Polyester und/oder hydroxyfunktioneller Polyurethane und geeigneten Photoinitiatoren aufgebaut.

Beispiele für geeignete cycloaliphatische Epoxide sind die Epoxide von cycloaliphatischen Estem von Dicarbonsäuren wie bis-(3,4-Epoxycyclohexylmethyl)oxalat, bis-(3,4-Epoxy-cyclohexylmethyl)adipat, bis-(3,4-Epoxy-6-Methylcyclohexylmethyl)adipat, bis-(3,4-Epoxycyclohexylmethyl)pimelat. Weitere geeignete Diepoxide von cycloaliphatischen Estern sind z.B. in der US-A-2750395 beschrieben.

Weitere geeignete cycloaliphatische Epoxide sind beispielsweise 3,4-Epoxycyclohexylmethyl-3,4-Epoxycyclohexancarboxylat, bis-(3,4-Epoxycyclohexyl)adipat, 3,4-Epoxy-1-Methylcyclohexylmethyl-3,4-epoxy-1-methylcyclohexancarboxylat. Weitere geeignete cycloaliphatische Epoxide sind beispielsweise in der US-A-2890194 beschrieben.

Als Reaktivverdünner können entweder Mischungen von niedrigviskosen cycloaliphatischen Epoxiden oder bevorzugt 1,2-Epoxyalkane wie z.B. 1,2-Epoxyhexadecan oder die monofunktionellen Glycidylether von Alkanolen eingesetzt werden.

Als Polyole können die an sich bekannten OH-funktionellen Polyester auf der Basis aliphatischer oder aromatischer Dicarbonsäuren und niedermolekularen Glykolen eingesetzt werden, z.B. Polyester auf der Basis von Adipinsäure, Sebazinsäure, Isophthalsäure und Glykolen wie Ethylenglykol, Diethylenglykol, Triethylenglykol, Neopentylglykol, Hexandiol und ähnlichen. Weiterhin können die an sich bekannten hydroxyterminierten Polycaprolactone eingesetzt werden.

Weitere OH-terminierte Prepolymere können die an sich bekannten Umsetzungsprodukte aus Polyetherpolyolen und/oder Polyesterpolyolen und Diisocyanaten sein, sofern das Molekulargewicht niedrig genug ist, um eine niederviskose Primerzusammensetzung gewährleisten zu können.

Als Photoinitiatoren kommen prinzipiell alle sogenannten "Onium"-Salze in Frage, wie sie z.B. durch F. Lohse und H. Zweifel in Adv. Polym. Sci. 1986, S. 61 bis 81 beschrieben sind. Insbesondere bevorzugt sind die gemischten Triarylsulphoniumhexafluoroantimonate und die gemischten Triarylsulfoniumhexafluorophosphate, wie sie beispiels-weise unter dem Namen Cyracure der Fa. Union Carbide im Handel sind.

Zur Strahlenhärtung können handelsübliche Elektronenstrahlhärtungsanlagen und UV-Polymerisationsanlagen verwendet werden. Nachfolgend wird die Erfindung anhand einiger bevorzugter Ausführungsbeispiele näher erläutert.

### Beispiel 1

Es wurde eine Mischung aus 59,83 Gew.% eines Polyesters auf Basis Isophthalsäure, Adipinsäure, Diethylenglykol mit der OH-Zahl 23,5 (DIN 53240), 19,94 Gew.% eines Polyesters auf Basis Adipinsäure, Neopentylglykol, Hexandiol, Ethylenglykol und 6-Hydroxyhexansäure, (OH-Zahl 21), 17,31 Gew.% 3,4-Epoxycyclohexylmethyl-3,4-Epoxycyclohexancarboxylat und 2,91 Gew.% eines gemischten Triarylsulfoniumhexafluorophosphates (Cyracure UVI 6990, Fa. Union Carbide) hergestellt. Dieser Primer hatte eine BrookfieldViskosität von 3.800 mPas bei 80 °C (Brookfield RVTD-II, Sp.27).

### Beispiel 2

Es wurde eine Mischung aus 31,81 Gew.% 3,4-Epoxycyclo-hexylmethyl-3,4-epoxycyclohexancarboxylat, 3,27 Gew.% eines Polycaprolactontriols (OH-Zahl 307,5) 2,90 Gew.% Photoinitiator Cyracure UVI 6990 und einem OH-terminierten Polyurethanprepolymer auf der Basis von 9,18 Gew.% eines Polypropylenglykols (OH-Zahl 256) 42,34 Gew.% eines hydroxyfunktionellen Polyesters mit der OH-Zahl 111 und 11,50 Gew.% 4,4'-Diphenylmethandiisocyanat hergestellt. Die Brookfield-Viskosität dieses Primers betrug 2400 mPas bei 70°C (RVTD-II, Spindel 27).

### Beispiel 3 (Vergleichsbeispiel)

Es wurde eine wässrige Polyurethandispersion mit aliphatischem Isocyanathärter auf der Basis Liofol® A 8219-21/UR5888-21 (Handelsprodukte der Fa. Henkel) im Verhältnis 100:6 hergestellt.

### Beispiel 4 (Vergleich)

Als Vergleichsbeispiel für einen lösungsmittelhaltigen Primer auf Basis eines feuchtigkeitshärtenden Polyurethanprepolymers wurde Liofol® UK 4500 der Henkel verwendet.

### Austestung der Primer

Die Primer gemäß Beispiel 1 bis 4 wurden bei der PVDC-Beschichtung von einer Folie aus orientiertem Polypropylen (OPP) (20 um, MB200 der Fa. Mobil) verwendet. Dazu wurden die Primer mit einem Mehrwalzenauftragswerk bei 70 °C (Primer 2) bzw. 80 °C (Primer 1) auf die Corona-vorbehandelte Seite der OPP-Folie aufgetragen. Bei den erfindungsgemäßen Primem erfolgte der Auftrag mit einer Maschinengeschwindigkeit von 5m/min, wobei die Beschichtung an einer Quecksilberdampflampe mit ca. 30 W/cm Strahlungsleistung vorbeigeführt wurde. Bei den lösungsmittelhaltigen bzw. wässrigen Primem der Vergleichsversuche wurden die Primerschichten nicht bestrahlt, sondern das Lösungsmittel bzw. das Wasser vollständig abgedampft.

Die PVDC-Beschichtung erfolgte mit Diofan® 193D der Fa. BASF, dem 2% Gleitmittel-Dispersion und 0,2% Syloid® 244 der Fa. Grace zugesetzt wurde. Auftragsgewicht der PVDCSchicht 4,5 bis 5g/m² (trocken).

Die Prüfung der Primerwirksamkeit bei diesen Beschichtungen wurde durch Siegelung der PVDC-Seite der beschichteten Folie gegen sich selbst geprüft, wobei die Versiegelung bei 140 °C/0,25s/2,5bar vorgenommen wurde. Die Prüfung dieser so hergestellten Siegelnaht erfolgte in einer Zugprüfmaschine bei einer Vorzugsgeschwindigkeit von 150 mm/min an 15 mm breiten Streifen. Die Testergebnisse sind in der nachfolgenden Tabelle aufgeführt.

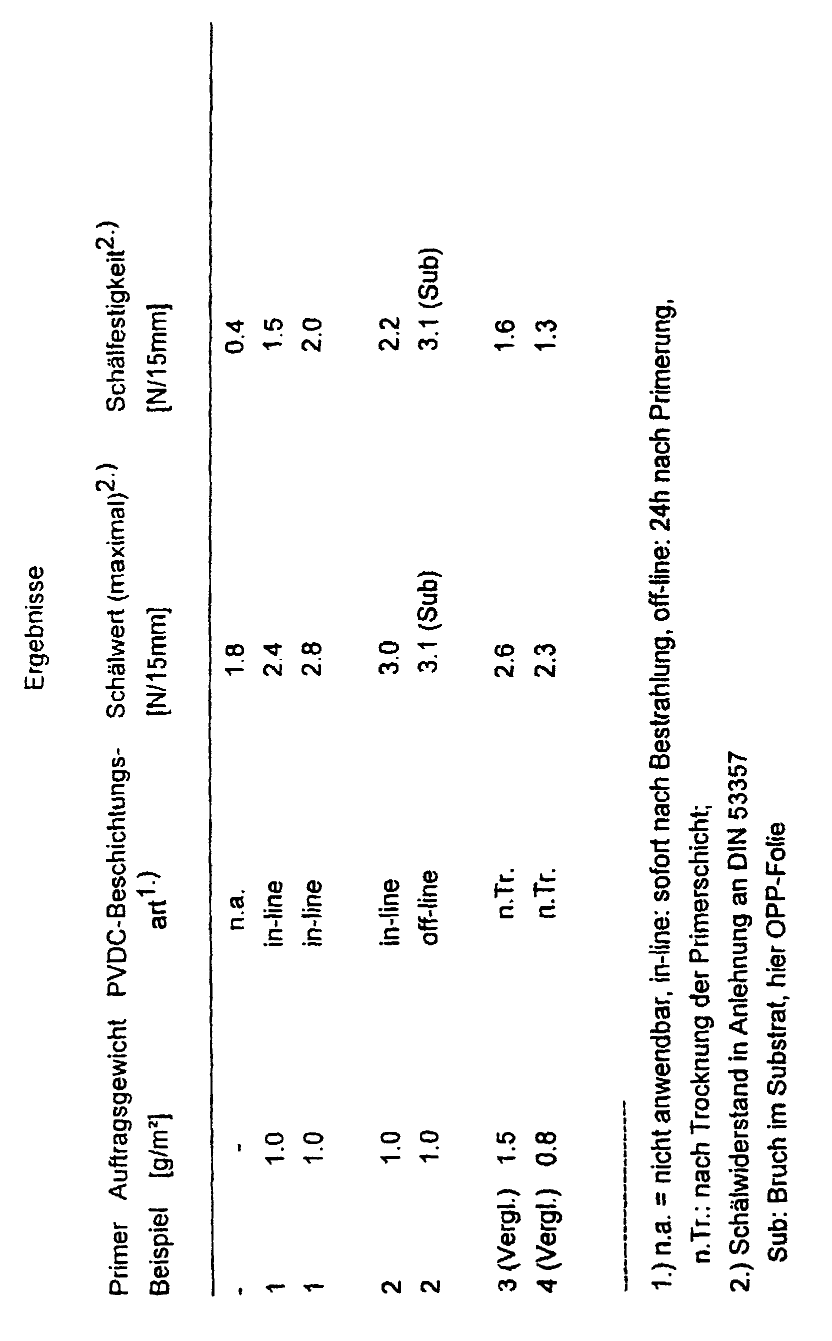

Wie aus den Versuchsergebnissen ersichtlich, ist mit den erfindungsgemäßen strahlenhärtbaren Primer-Zusammensetzungen ein Primerauftrag mit ähnlich niedrigem Auftragsgewicht möglich wie mit den lösungsmittelhaltigen bzw. wässrigen Primem des Standes der Technik, wobei die Schälfestigkeit sowohl in bezug auf Maximalwert als auf den Durchschnittswert zum Teil erheblich bessere Ergebnisse liefert als bei den Primern des Standes der Technik.

## Patentansprüche

1. Verwendung einer strahlenhärtbaren lösungsmittelfreien Zusammensetzung, enthaltend kationisch und/oder radikalisch härtbare Vernetzungssysteme, als Haftvermittler

2. Verwendung gemäß Anspruch 1, **dadurch gekennzeichnet, daß** die Viskosität der strahlenhärtbaren Zusammensetzungen bei einer Verarbeitungstemperatur von unter 150 °C, vorzugsweise unter 100 °C eine Viskosität <5000mPa's, gemessen mit einem Brookfield RVTD-II-Viskosmeter, haben.

3. Verwendung gemäß einem der vorhergehenden Ansprüche, **dadurch gekennzeichnet, daß** die kationisch härtbaren Vernetzungssysteme cycloaliphatische Epoxide und/oder Vinylether und Photoinitiatoren enthalten.

4. Verwendung gemäß mindestens einem der vorhergehenden Ansprüche, **dadurch gekennzeichnet, daß** die radikalisch härtbaren Vernetzungssysteme Verbindungen mit olefinisch ungesättigten Doppelbindungen wie z.B. Styrol-, Acrylat- und/oder Methacrylatmonomere sowie ggf. einen oder mehrere Photoinitiatoren und/oder einen oder mehrere Radikalstarter auf der Basis von Hydroperoxiden, Peroxiden oder Azoverbindungen enthalten.

5. Verwendung gemäß mindestens einem der vorhergehenden Ansprüche, **dadurch gekennzeichnet, daß** UV-Strahlung oder Elektronen-Bestrahlung zur Härtung/Vernetzung verwendet wird.

6. Verwendung nach einem der Ansprüche 1 bis 4, **gekennzeichnet durch** die folgenden Merkmale:
a) das ggf. Corona-vorbehandelte Substrat wird mit einer Primerzusammensetzung nach einem der Ansprüche 1 bis 4 beschichtet,
b) die Primerschicht wird mit UV-Strahlung oder Elektronenstrahlung bestrahlt,
c) ohne weiteren Trocknungsschritt wird unmittelbar anschließend (in-line) oder in einem separaten Arbeitsschritt (off-line) eine Beschichtung mit Schmelzklebstoffen, PVDC-Dispersionen, Heißsiegellacken, Druckfarben, Lacken oder ähnlichen Beschichtungsmaterialien vorgenommen.

7. Verwendung nach Anspruch 1 zur Erzeugung von haftvermittelnden Beschichtungen für die Kaschierverklebung von Metall- und/oder Kunststoff-Folien mit Schmelzklebstoffen oder Heißsiegellacken, für die PVDC-Beschichtung von Kunststoff-Folien, für die Extrusionsbeschichtung oder Extrusionskaschierung von Polyethylen- oder Polypropylenfolien, für die Metallisierung von Kunststof-Folien oder für das Bedrucken und/oder die Lackierung von Kunststoff-Folien.

## Claims

1. The use of a radiation-curable solventless compositions containing cationically and/or radically curable crosslinking systems as a coupling agent.

2. The use claimed in claim 1, **characterized in that** the radiation-curable compositions have a viscosity at a processing temperature below 150°C and preferably below 100°C of < 5,000 mPa.s, as measured with a Brookfield RVTD-II viscosimeter.

3. The use claimed in any of the preceding claims, **characterized in that** the cationically curable crosslinking systems contain cycloaliphatic epoxides and/or vinyl ethers and photoinitiators.

4. The use claimed in at least one of the preceding claims, **characterized in that** the radically curable crosslinking systems contain compounds with olefinically unsaturated double bonds such as, for example, styrene, acrylate and/or methacrylate monomers and optionally one or more photoinitiators and/or one or more radical initiators based on hydroperoxides, peroxides or azo compounds.

5. The use claimed in at least one of the preceding claims, **characterized in that** UV radiation or electron beams is/are used for curing/crosslinking.

6. The use claimed in any of claims 1 to 4, **characterized by** the following features:
a) the optionally corona-pretreated substrate is coated with the primer composition claimed in any of claims 1 to 4,
b) the primer layer is exposed to UV radiation or electron beams,
c) without a further drying step, the substrate is coated either immediately afterwards (in-line) or in a separate process step (off-line) with hotmelt adhesives, PVDC dispersions, heat sealing lacquers, printing inks, lacquers or similar coating materials.

7. The use claimed in claim 1 for obtaining coupling coatings for the lamination bonding of metal and/or plastic films with hotmelt adhesives or heat sealing lacquers, for the PVDC coating of plastic films, for the extrusion coating or extrusion laminating of polyethylene or polypropylene films, for the metallizing of plastic films or for the printing and/or lacquering of plastic films.

## Revendications

1. Utilisation d'une composition exempte de solvant, durcissable par un rayonnement, qui contient un système de réticulation durcissable par voie cationique et/ou radicalaire, en tant qu'adhésiphore.

2. Utilisation conformément à la revendication 1,
**caractérisée en ce que**
les compositions durcissables par rayonnement à une température de façonnage inférieure à 150°C, de préférence en dessous de 100°C, ont une viscosité de <5000 mPas mesurée avec un viscosimètre Brookfield RVTD-II.

3. Utilisation conformément à l'une des revendications précédentes,
**caractérisée en ce que**
les systèmes de réticulation durcissables par voie cationique renferment des époxydes cycloaliphatiques et/ou de l'éther vinylique et des photo-initiateurs.

4. Utilisation conformément à au moins l'une des revendications précédentes,
**caractérisée en ce que**
les systèmes de réticulation durcissables par voie radicalaire renferment des substances ayant des doubles liaisons non saturées oléfiniquement, comme par exemple des monomères de styrène, d'acrylate et/ou de méthacylate ainsi qu'éventuellement un ou plusieurs photoinitiateurs et/ou un ou plusieurs déclencheurs de radicaux à base d'hydroperoxydes, de peroxydes ou de composés azo.

5. Utilisation conformément à au moins une des revendications précédentes,
**caractérisée en ce que**
on utilise un rayonnement UV ou une irradiation par les électrons en vue du durcissement/réticulation.

6. Utilisation selon l'une des revendications 1 à 4,
**caractérisée en ce que**
par les caractéristiques suivantes
a) le substrat éventuellement pré-traité par l'effet Corona est enduit d'une composition d'enduit primaire selon l'une des revendication 1 à 4,
b) la couche d'enduit primaire est irradiée avec un rayonnement par les UV ou par irradiation à l'aide d'électrons,
c) sans autre étape de séchage on effectue directement ensuite (in line) ou dans une étape de travail séparée (off-line) un revêtement avec des substances de colle par fusion, des dispersions de PVDC, de laques de thermosoudage, de couleurs d'impression, de laques ou de matériaux de revêtements similaires.

7. Utilisation selon la revendication 1, pour la production de revêtements qui favorisent l'adhésion pour l'encollage, de feuilles de métal et/ou de matières plastiques, pour le revêtement par extrusion le Kaschierung par extrusion de feuilles de polyéthylène ou de polypropylène, pour la métallisation de feuilles de matière plastique ou pour l'impression et/ou de laquage de feuilles de matière plastique.
